# EUROPEAN PATENT APPLICATION

(11) **EP 4 481 823 A1**
(43) Date of publication of application: **25.12.2024**
(21) Application number: 22926120.1
(22) Date of filing: 27.12.2022
(51) Int. Cl.: H01L 27/146

(54) **SOLID-STATE IMAGING DEVICE AND METHOD FOR MANUFACTURING SOLID-STATE IMAGING DEVICE**

(30) Priority: 14.02.2022 JP 2022020874
(71) Applicant: Sony Semiconductor Solutions Corporation, Atsugi-shi, Kanagawa 243-0014 (JP)
(72) Inventor: JOEI, Masahiro, Atsugi-shi, Kanagawa 243-0014 (JP)
(74) Representative: Müller Hoffmann & Partner
(86) International application number: PCT/JP2022/048306
(87) International publication number: WO 2023/153106

(57) **Abstract**

A solid-state imaging device includes: an oxide semiconductor layer disposed above a substrate; a photoelectric conversion layer stacked on the oxide semiconductor layer on an opposite side of the substrate; and an insulating separator disposed in the oxide semiconductor layer between pixels, in which the insulation separator includes an insulator.

## Description

### Technical Field

The present disclosure relates to a solid-state imaging device and a method of manufacturing the solid-state imaging device.

### Background Art

PTL 1 discloses an imaging element, a stacked imaging element, and a solid-state imaging device. The imaging element includes a first electrode, a photoelectric conversion layer including an organic material, and a second electrode. This imaging element has an oxide semiconductor layer formed between the first electrode and the photoelectric conversion layer.

### Citation List

### Patent Literature

PTL 1: International Publication No. WO2020/017330

### Summary of the Invention

For the imaging element described above, it is desired to effectively suppress or prevent dark current flowing through the oxide semiconductor layer in a region corresponding between pixels.

A solid-state imaging device according to a first embodiment of the present disclosure includes: an oxide semiconductor layer disposed above a substrate; a photoelectric conversion layer stacked on the oxide semiconductor layer on an opposite side of the substrate; and an insulating separator disposed in the oxide semiconductor layer between pixels, the insulation separator including an insulator.

A method of manufacturing a solid-state imaging device according to a second embodiment of the present disclosure includes: forming an oxide semiconductor layer above a substrate; forming a separation groove between regions where pixels are to be formed, the separation groove being formed in a thickness direction of the oxide semiconductor layer from a surface of the oxide semiconductor layer on an opposite side of the substrate; forming an insulating separator by embedding an insulating film in the separation groove; and forming a photoelectric conversion layer on the surface.

### Brief Description of Drawing

[FIG. 1] FIG. 1 is a diagram illustrating a vertical cross-sectional configuration of a portion of a pixel of a solid-state imaging device according to a first embodiment of the present disclosure.
[FIG. 2] FIG. 2 is a diagram illustrating a planar configuration of the pixel in FIG. 1;
[FIG. 3] FIG. 3 is a diagram illustrating a vertical cross-sectional view of the main part of the pixel in FIG. 2 (cross-sectional view taken along the A-A line in FIG. 2).
[FIG. 4] FIG. 4 is a graph to describe workings and effects of the solid-state imaging device according to the first embodiment, compared to the solid-state imaging device according to the comparative example.
[FIG. 5] FIG. 5 is a conceptual diagram corresponding to FIG 3, which explains workings and effects of the solid-state imaging device according to the first embodiment.
[FIG. 6] FIG. 6 is a graph illustrating the relationship between the thickness of the oxide semiconductor layer and noise, which explains workings and effects of the solid-state imaging device according to the first embodiment.
[FIG. 7] FIG. 7 is a cross-sectional view of a first process corresponding to FIG. 3, which explains the method of manufacturing the solid-state imaging device according to the first embodiment.
[FIG. 8] FIG. 8 is a cross-sectional view of a second process.
[FIG. 9] FIG. 9 is a cross-sectional view of a third process.
[FIG. 10] FIG. 10 is a cross-sectional view of a fourth process.
[FIG. 11] FIG. 11 is a cross-sectional view of a fifth process.
[FIG. 12] FIG. 12 is a cross-sectional view of a sixth process.
[FIG. 13] FIG. 13 is a diagram illustrating a vertical cross-sectional configuration of the main part of a pixel of a solid-state imaging device according to a second embodiment of the present disclosure, corresponding to FIG. 3.
[FIG. 14] FIG. 14 is a cross-sectional view of a first process corresponding to FIG. 3, which explains the method of manufacturing the solid-state imaging device according to the second embodiment.
[FIG. 15] FIG. 15 is a cross-sectional view of a second process.
[FIG. 16] FIG. 16 is a cross-sectional view of a third process.
[FIG. 17] FIG. 17 is a cross-sectional view of a fourth process.
[FIG. 18] FIG. 18 is a diagram illustrating a vertical cross-sectional configuration of the main part of a pixel of a solid-state imaging device according to a third embodiment of the present disclosure, corresponding to FIG. 3.

### Modes for Carrying Out the Invention

The following describes embodiments of the present disclosure in details with reference to the drawings. Note that the explanation will be given in the following order.

### 1. First Embodiment

The first embodiment describes an example of applying the present technology to a solid-state imaging device. The first embodiment describes a vertical cross-sectional configuration and a planar configuration of the solid-state imaging device. The first embodiment then describes a method of manufacturing the solid-state imaging device.

### 2. Second Embodiment

The second embodiment describes a first example of changing the configuration of the insulating separator of the solid-state imaging device according to the first embodiment. The second embodiment then describes a method of manufacturing the solid-state imaging device.

### 3. Third Embodiment

The third embodiment describes a second example of changing the configuration of the insulating separator of the solid-state imaging device according to the first embodiment.

### 4. Other Embodiments

### <1. First Embodiment>

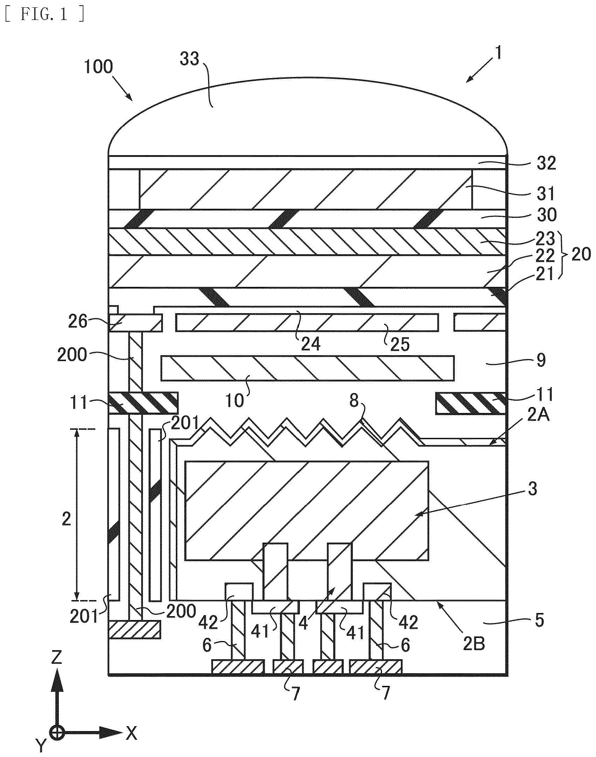

Referring to FIGs. 1 to 12, the following describes a solid-state imaging device 1 according to the first embodiment of the present disclosure and a method of manufacturing the solid-state imaging device 1.

Here, the direction of arrow X in the drawings illustrated as appropriate indicates one planar direction of the solid-state imaging device 1 placed on a plane for convenience. The direction of arrow Y indicates another plane direction orthogonal to the arrow X direction. The direction of arrow Z indicates upward direction orthogonal to the arrow X direction and arrow Y direction. That is, the arrow X direction, arrow Y direction, and arrow Z direction exactly coincide with the X-axis direction, Y-axis direction, and Z-axis direction, respectively, of the three-dimensional coordinate system.

Note that these directions are illustrated to help understand the explanation, and do not limit the directions of the present technology.

### [Configuration of Solid-State Imaging Device 1]

### (1) Overall configuration of solid-state imaging device 1

FIG. 1 illustrates an example of a vertical cross-sectional configuration of a pixel 100 of a solid-state imaging device 1.

The solid-state imaging device 1 according to the first embodiment is able to acquire visible-light information and distance information using a common pixel 100. The solid-state imaging device 1 includes a substrate 2, a first photoelectric converter 3, and a second photoelectric converter 20. The solid-state imaging device 1 further includes a first filter 10, a second filter 31, and an optical lens 33.

### (2) Configuration of substrate 2

Letting that the arrow Z direction is the thickness direction, the substrate 2 has a first surface (top surface) 2A that extends in the arrow X and arrow Y directions, and a second surface (bottom surface) 2B facing the first surface 2A. Light enters from the first surface 2A.

For instance, the substrate 2 used is a semiconductor substrate including single crystal silicon (Si). Although not clearly illustrated, a p-type well region of a first conductivity type is formed in the semiconductor substrate.

### (3) Configuration of first photoelectric converter 3

A first photoelectric converter 3 is formed in the substrate 2 at the region corresponding to a single pixel 100. The first photoelectric converter 3 converts light into electric charge.

Although a detailed description of the configuration is omitted, the first photoelectric converter 3 includes a photodiode. The photodiode is formed at a pn junction between an n-type semiconductor region and a p-type semiconductor region. For instance, the first photoelectric converter 3 in this embodiment is configured to be sensitive to all visible light from blue light to red light.

The first photoelectric converter 3 is coupled to a wiring 7 with a transfer transistor 4 interposed therebetween, the transfer transistor 4 being disposed on the second surface 2B of the substrate 2.

The transfer transistor 4 includes a gate electrode 41 and a pair of main electrodes. Note here that the transfer transistor 4 includes an n-channel insulated gate field effect transistor (IGFET). IGFET refers to both a metal insulator semiconductor field effect transistor (MISFET) and a metal oxide semiconductor field effect transistor (MOSFET).

One of the main electrodes of the transfer transistor 4 includes the photodiode of the first photoelectric converter 3. The other main electrode includes a floating electrode 42 disposed on the second surface 2B of the substrate 2. The floating electrode 42 in this embodiment includes an n-type semiconductor region (n-type diffusion region).

The transfer transistor 4 transfers the electric charge converted from light at the first photoelectric converter 3 to the floating electrode 42 in accordance with a control signal applied to the gate electrode 41.

The wiring 7 is disposed below the second surface 2B of the substrate 2 with an insulating layer 5 interposed therebetween. The wiring 7 is electrically coupled to the floating electrode 42 through a connection hole wiring 6 that penetrates the insulating layer 5 in the thickness direction.

For instance, the wiring 7 includes copper (Cu). For instance, the connection hole wiring 6 includes a conductive metal material such as tungsten (W).

Note here that, although not illustrated in FIG. 1, a circuit for constituting an indirect time of flight (iToF) sensor is disposed at the second surface 2B of the substrate 2. An iToF sensor accumulates incident light and detects the phase difference between the incident light and the emitted light, thus making it possible to measure a distance.

### (4) Configuration of first filter 10

The first filter 10 is disposed above the first surface 2A of the substrate 2 with a fixed charge layer 8 interposed therebetween. The first filter 10 is disposed in an insulating layer 9 formed on the first surface 2A of the substrate 2. The first filter 10 in this embodiment is configured to block visible light and transmit infrared light. That is, when using infrared light at the substrate 2, the first filter 10 is able to reduce color mixing between the infrared light and ultraviolet light.

The first filter 10 may be configured to block visible light and transmit blue light. That is, when using blue light at the substrate 2, the first filter 10 is able to reduce color mixing between the blue light and ultraviolet light.

The fixed charge layer 8 is disposed between the first surface 2A of the substrate 2 and the insulating layer 9. In this embodiment, viewed in the arrow Y direction (hereinafter simply referred to as "in lateral view"), the fixed charge layer 8 has a cross-sectional shape that alternates between protruding toward the light-entering side and protruding toward the opposite side of the light-entering in the arrow X direction. In other words, the fixed charge layer 8 has a zigzag shape in cross section. A negative charge is applied to the fixed charge layer 8.

The fixed charge layer 8 configured in this way is able to confine infrared light, for example, within the substrate 2. Alternatively, the fixed charge layer 8 is able to blue light, for example, within the substrate 2.

Note that between the pixels 100, an inter-pixel light shielding layer 11 is disposed between the first filter 10 and the fixed charge layer 8. The inter-pixel light shielding layer 11 is able to reduce color mixing of light between the pixel 100 and other pixels 100 adjacent thereto.

### (5) Configuration of second photoelectric converter 20

The second photoelectric converter 20 is opposed to the first photoelectric converter 3 with the first filter 10 interposed therebetween. The second photoelectric converter 20 includes an oxide semiconductor layer 21, a photoelectric conversion layer 22, and a transparent electrode 23.

The oxide semiconductor layer 21 is opposed to the first surface 2A of the substrate 2. Specifically, the oxide semiconductor layer 21 is opposed to the first filter 10 with a storage electrode 25 and an insulating film 24 interposed therebetween.

The oxide semiconductor layer 21 is transparent semiconductor that transmits electromagnetic waves in the visible light range, and accumulates electrons converted from light at the photoelectric conversion layer 22. The oxide semiconductor layer 21 includes IGZO containing indium (In), gallium (Ga), zinc (Zn), and oxygen (O), for example. The oxide semiconductor layer 21 may include IGSiO containing In, Ga, Si, and O and IAZO containing In, aluminum (Al), Zn, and O.

For instance, the oxide semiconductor layer 21 has a thickness of 10 nm or more and 100 nm or less.

The photoelectric conversion layer 22 is stacked on the oxide semiconductor layer 21. The photoelectric conversion layer 22 includes a photoelectric conversion material that is sensitive to green light, for example. This photoelectric conversion material includes an organic photoelectric conversion material such as rhodamine dyes, merocyanine dyes, or quinacridone.

For instance, the photoelectric conversion layer 22 has a thickness of 100 nm or more and 1000 nm or less.

The transparent electrode 23 is stacked on the photoelectric conversion layer 22. The transparent electrode 23 includes indium oxide-zinc oxide series oxide (IZO), for example. The transparent electrode 23 may also include indium tin oxide (ITO).

For instance, the transparent electrode 23 has a thickness of 10 nm or more and 100 nm or less.

The storage electrode 25 stores the electric charge, which is converted from light at the second photoelectric converter 20, in the oxide semiconductor layer 21. The stored electric charge is read out by a readout electrode 26. The storage electrode 25 is disposed between the first filter 10 and the oxide semiconductor layer 21. The insulating film 24 is disposed between the storage electrode 25 and the oxide semiconductor layer 21. Similar to the transparent electrode 23, the storage electrode 25 includes a transparent electrode material, for example. The insulating film 24 operates as a gate insulating film. In other words, the storage electrode 25, insulating film 24, and oxide semiconductor layer 21 constitute a metal-insulator-semiconductor type capacitance.

The readout electrode 26 is disposed in the same layer as the storage electrode 25. When a control signal is applied to the readout electrode 26, the readout electrode 26 transfers the electric charge accumulated in the circuit disposed at the second surface 2B of the substrate 2 through a feedthrough wiring 200. The feedthrough wiring 200 penetrates the substrate 2 in the thickness direction.

A light shielding wall 201 is also disposed between the substrate 2 and the feedthrough wiring 200 to cover the periphery of the lateral surface of the feedthrough wiring 200. The light shielding wall 201 is able to reduce color mixing.

### (6) Configuration of second filter 31

The second filter 31 is opposed to the second photoelectric converter 20 on the opposite side of the first filter 10 with a sealing film 30 interposed therebetween. The second filter 31 is able to transmit visible light including red light, green light, and blue light, for example. The sealing film 30 includes an insulating film containing Al and titanium (Ti) or an insulating film such as silicon nitride (SiN), for example.

Note that the second filter 31 is not necessary for the solid-state imaging device 1 that detects only black and white incident light.

### (7) Configuration of optical lens 33

The optical lens 33 is opposed to the second filter 31 on the opposite side of the second photoelectric converter 20 with a planarizing film 32 interposed therebetween. The optical lens 33 in this embodiment includes an on-chip lens.

### [Specific Configuration of Pixel 100]

### (1) Specific planar configuration and specific cross-sectional configuration of pixel 100

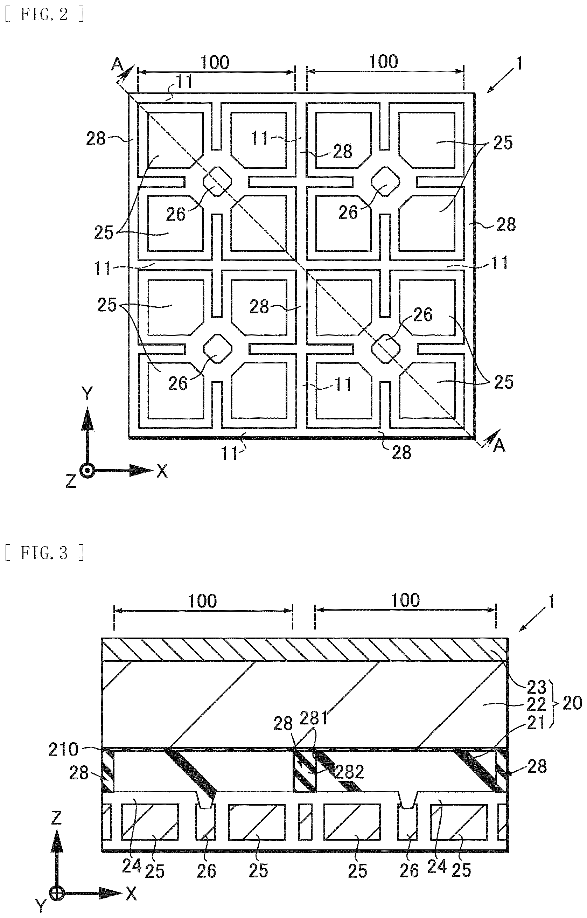

FIG. 2 illustrates an example of the specific planar configuration of pixels 100. FIG. 3 illustrates an example of the specific cross-sectional configuration of pixels 100.

One pixel 100 has a rectangular shape, viewed in the direction of arrow Z (hereinafter simply referred to as "plan view"). In this example, the pixel 100 has a square shape. In plan view, the pixels 100 are regularly arranged at the equal intervals in each of the arrow X direction and the arrow Y direction. That is, the pixels 100 are arranged in a matrix shape.

In a region surrounded by the inter-pixel light shielding layer 11, the second photoelectric converter 20 is disposed over almost the entire region of the pixel 100. In this embodiment, two storage electrodes 25 are disposed in each of the arrow X direction and the arrow Y direction, that is, a total of four storage electrodes 25 is disposed.

One readout electrode 26 is disposed in the middle of the storage electrodes 25 arranged that are four in total (at the middle of the pixels 100).

As illustrated in FIG. 3 as lateral view, the second photoelectric converter 20 includes an oxide layer 210 disposed between the oxide semiconductor layer 21 and the photoelectric conversion layer 22. The oxide layer 210 makes it possible to improve oxygen deficiency near the surface of the oxide semiconductor layer 21 and improve the transfer characteristics of electric charge.

Although the detailed configuration is omitted, the oxide layer 210 includes a film stack of a metal oxide film and a tunnel oxide film.

The metal oxide film includes at least one element selected from tantalum (Ta), Ti, palladium (Pd), niobium (Nb), tungsten (W), zirconium (Zr), hafnium (Hf), scandium (Sc), yttrium (Y), lanthanum. (La), gallium (Ga), and manganese (Mg).

The tunnel oxide film includes at least one material selected from SiOₓ, SiON, SiOC, and AlOY.

The oxide layer 210 also includes at least one element added, which is selected from Si, Ta, Pd, Nb, W, Zr, Hf, Sc, Y, La, Ga, Mg, aluminum (Al), strontium (Sr), germanium (Ge), hydrogen (H₂), carbon (C), and nitrogen (N₂).

For instance, the oxide layer 210 has a thickness of 0.2 nm or more (approximately one atomic layer or more) and 10 nm or less.

### (2) Configuration of insulation separator 28

As illustrated in FIGs. 2 and 3, the solid-state imaging device 1 of the first embodiment includes the insulating separator 28 disposed in the oxide semiconductor layer 21 of the second photoelectric converter 20 between the pixels 100.

Specifically, the insulating separator 28 surrounds a pixel 100 in plan view. The insulating separator 28 also surrounds at least the lateral periphery of the oxide semiconductor layer 21 in lateral view.

The insulating separator 28 includes a separation groove 281 and an insulating film 282.

The separation groove 281 penetrates from the top surface of the oxide semiconductor layer 21 on a side of the second filter 31 to the bottom surface on a side of the first filter 10. In this embodiment, the separation groove 281 has a constant width.

Note that the separation groove 281 may have a tapered shape, a stepped shape, and other shapes that are different in width between the top surface and the bottom surface of the oxide semiconductor layer 21.

The insulating film 282 is embedded in the separation groove 281. In the first embodiment, the insulating film 282 includes silicon oxide (SiO₂), for example. SiO₂ has electrical insulating properties and further is able to repair oxygen defects in the oxide semiconductor layer 21.

That is, the insulating separator 28 is able to block the flow of electric charge, specifically the flow of dark current, which causes noise between adjacent pixels 100. In addition, the insulating separator 28 is able to repair oxygen defects in the oxide semiconductor layer 21 of the second photoelectric converter 20, thus making it possible to improve the transfer efficiency of electric charge.

The insulating film 282 of the insulating separator 28 may also include one or more insulating materials selected from silicon oxynitride (SiON), aluminum oxide (AlO), titanium oxide (TiO), and titanium oxide silicide (TiSiO). These insulating materials are able to effectively inhibit the ingress of H₂, thus making it possible to improve sealing performance.

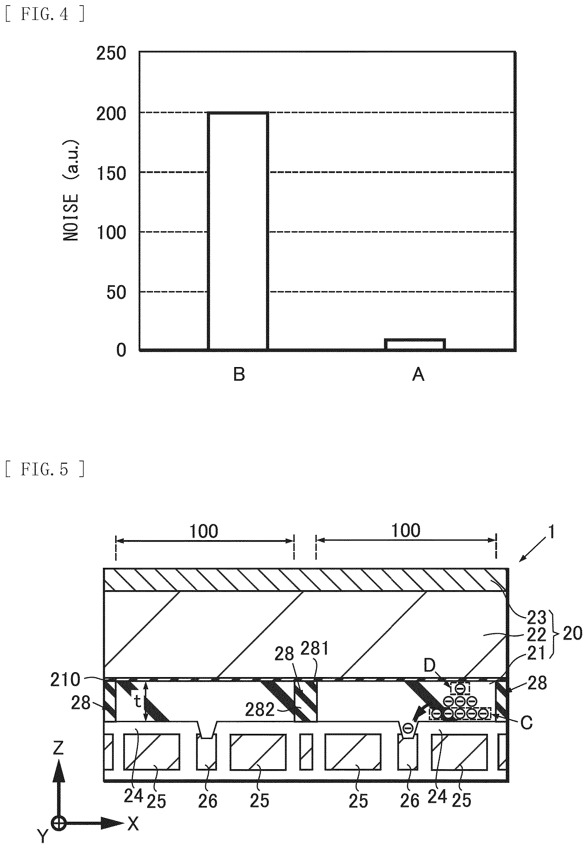

FIG. 4 is an example graph representing noise characteristics.

Letter A on the horizontal axis in FIG. 4 indicates the noise characteristics of the solid-state imaging device 1 according to the first embodiment. Letter B indicates the noise characteristics of a solid-state imaging device according to a comparative example. The vertical axis represents noise (a.u.).

The solid-state imaging device 1 of the first embodiment includes the insulating separator 28 in the oxide semiconductor layer 21 of the second photoelectric converter 20 between the pixels 100. This makes it possible to significantly reduce noise compared to the solid-state imaging device of the comparative example.

FIG. 5 illustrates a specific cross-sectional configuration of a pixel 100, conceptually illustrating the state of electron density.

In the region indicated by letter C in FIG. 5, that is, adjacent to the storage electrode 25 of the oxide semiconductor layer 21, the electron density is 1×10¹⁹ cm³, for example, upon operations including charge storage and charge transfer operations.

In the region indicated by letter D, that is, adjacent to the photoelectric conversion layer 22 of the oxide semiconductor layer 21, the electron density is 1×10¹⁷ cm³ or less, for example, upon operations. The solid-state imaging device 1 of the first embodiment includes the oxide semiconductor layer 21 that is formed to have a thickness t, at which the electron density in region D is the above-described value or less. The electron density of the above-described value or less makes it possible to effectively suppress noise.

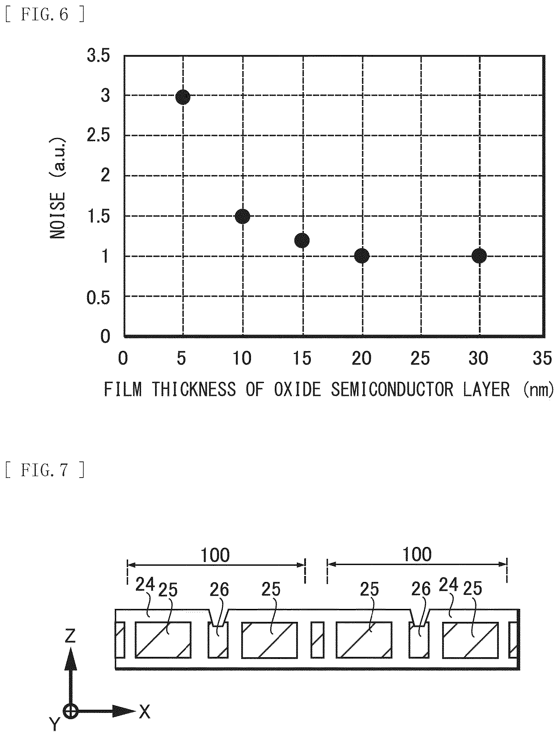

FIG. 6 illustrates an example of the relationship between the film thickness (thickness t) of the oxide semiconductor layer 21 and noise. The horizontal axis in FIG. 6 represents the thickness (nm) of the oxide semiconductor layer 21. The vertical axis represents noise (a.u.).

As illustrated in FIG. 6, the oxide semiconductor layer 21 of 20 nm or more in thickness hardly generates noise. Assuming this noise generation is set at "1", the effect of noise is ignorable when it is 1.5 times or less. Thus, the solid-state imaging device 1 of the first embodiment includes the oxide semiconductor layer 21 that has thickness t set at 10 nm or more.

### [Method of Manufacturing Solid-State Imaging Device 1]

FIGs. 7 to 12 illustrate the manufacturing method of the solid-state imaging device 1 according to the first embodiment, process by process. The following mainly describes the method of manufacturing the second photoelectric converter 20, while omitting the method of manufacturing the first photoelectric converter 3.

As illustrated in FIG. 7, the insulating film 24 is formed on the storage electrodes 25 in the region where the pixels 100 are to be formed. The insulating film 24 is also formed on the readout electrodes 26, but this insulating film 24 is removed to form openings. These openings are used for coupling the read electrode 26 to the corresponding feedthrough wiring 200. Note that the storage electrodes 25 and the readout electrodes 26 are formed above the first surface 2A of the substrate 2.

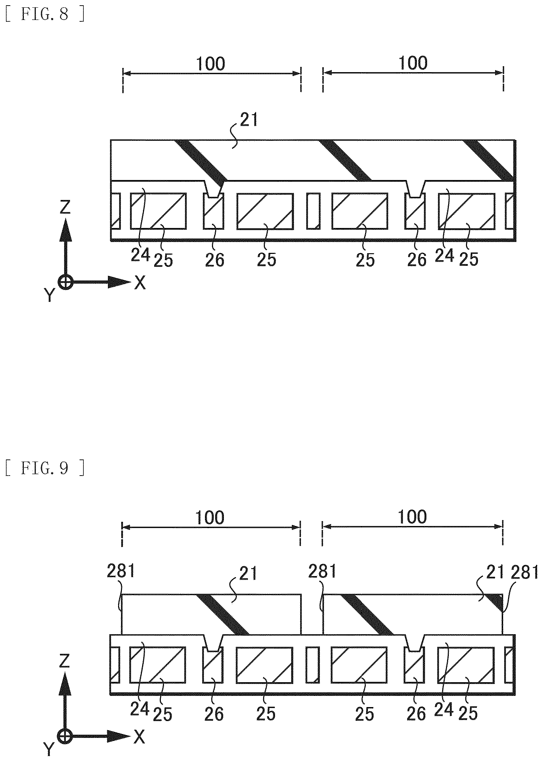

As illustrated in FIG. 8, the oxide semiconductor layer 21 of the second photoelectric converter 20 is formed on the insulating film 24. The oxide semiconductor layer 21 is coupled to the read electrodes 26 through the openings described above.

As illustrated in FIG. 9, the separation groove 281 is formed in the oxide semiconductor layer 21 between the regions where the pixels 100 are to be formed. To form the separation groove 281, a mask prepared by a photolithography technique and an anisotropic etching method such as reactive ion etching (RIE) are used, for example.

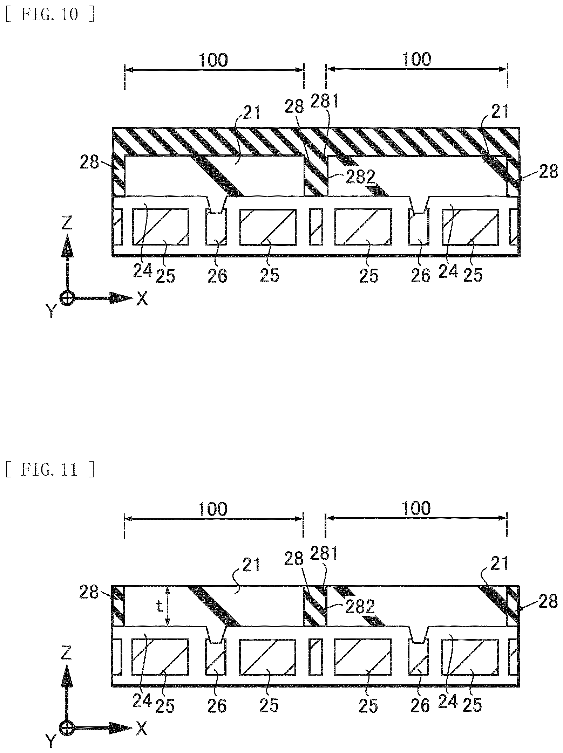

As illustrated in FIG. 10, the insulating film 282 is formed on the oxide semiconductor layer 21. The insulating film 282 is formed by a chemical vapor deposition (CVD) method, for example. The insulating film 282 formed is embedded in the separation groove 281.

As illustrated in FIG. 11, excess insulating film 282 on the oxide semiconductor layer 21 is removed, and a portion of the surface of the oxide semiconductor layer 21 is further removed to planarize the surface of the oxide semiconductor layer 21. For planarization, a chemical mechanical polishing (CMP) method is used, for example. The etch-back method is also used for the planarization.

The planarization forms the insulating separator 28 in the oxide semiconductor layer 21 between the regions where the pixels 100 are to be formed, and the insulating separator 28 includes the separation groove 281 and the insulating film 282.

In this process, damage occurs on the surface of the oxide semiconductor layer 21 due to the CMP method or the etch-back method. Thus, the oxide semiconductor layer 21 is formed to have a thickness t of 10 nm or more, for example (see FIG. 6). In addition, the oxide semiconductor layer 21 is formed to have a thickness t such that the electron density in the region D adjacent to the surface of the oxide semiconductor layer 21 is 1×10¹⁷ cm³ or less, for example, during the operation (see FIG. 5).

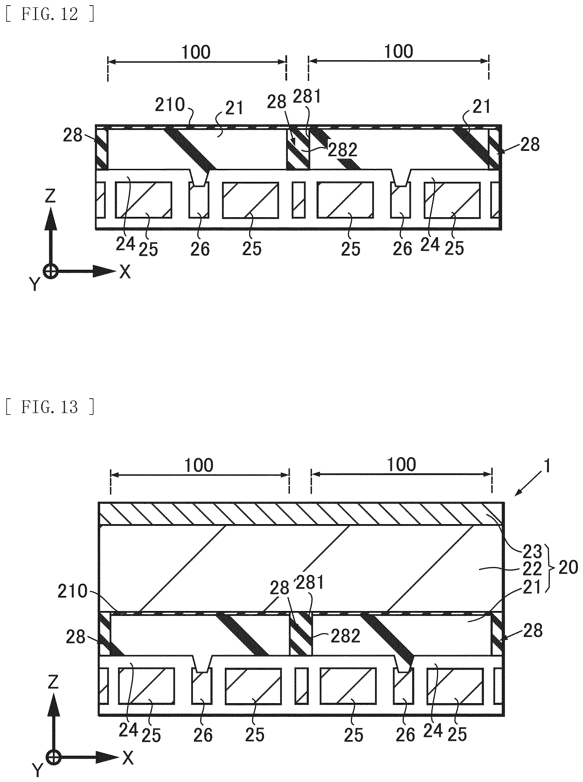

As illustrated in FIG. 12, the oxide layer 210 is formed on the oxide semiconductor layer 21.

The photoelectric conversion layer 22 is subsequently formed on the oxide layer 210, and the transparent electrode 23 is formed on the photoelectric conversion layer 22, as illustrated in FIG. 3 described above.

Thereafter, as illustrated in FIG. 1 described above, the sealing film 30, the second filter 31, the planarizing film 32, and the optical lens 33 are formed in sequence.

When a series of these manufacturing processes ends, the solid-state imaging device 1 according to the first embodiment is completed and the manufacturing method is finished.

### [Workings and Effects]

As illustrated in FIGs. 1 to 3, the solid-state imaging device 1 according to the first embodiment includes the oxide semiconductor layer 21 and the photoelectric conversion layer 22. The oxide semiconductor layer 21 is disposed above the substrate 2. The photoelectric conversion layer 22 is stacked on the oxide semiconductor layer 21 on the opposite side of the substrate 2.

In this embodiment, the solid-state imaging device 1 further includes the insulating separator 28. The insulating separator 28 is disposed in the oxide semiconductor layer 21 between the pixels 100 and includes an insulator.

With this configuration, as illustrated in FIG. 4, the insulating separator 28 is able to physically block the dark current flowing from a pixel 100 to the adjacent pixel 100 through the oxide semiconductor layer 21. This makes it possible to effectively suppress or prevent dark current, which is the cause of noise.

As illustrated in FIG. 3, in the solid-state imaging device 1, the position of the surface of the insulating separator 28 on a side of the photoelectric conversion layer 22 is the same as the position of the surface of the oxide semiconductor layer 21 on a side of the photoelectric conversion layer 22.

This configuration is able to reliably intercept the dark current flowing through the oxide semiconductor layer 21 because the insulating separator 28 is disposed in the entire thickness direction of the oxide semiconductor layer 21.

In addition, as illustrated in FIGs. 1 and 3, the oxide semiconductor layer 21 in the solid-state imaging device 1 includes IGZO, IGSiO, or IAZO. That is, any of the materials is able to effectively suppress or prevent dark current flowing through the oxide semiconductor layer 21.

In addition, as illustrated in FIGs. 1 and 3, the insulating separator 28 in the solid-state imaging device 1 includes SiO₂. In other words, the insulating film 282 of the insulating separator 28 includes SiO₂.

This means that the insulating separator 28 has electrical insulation properties and is also able to repair oxygen defects in the oxide semiconductor layer 21, thus making it possible to effectively suppress or prevent the dark current flowing through the oxide semiconductor layer 21, and improve the charge transfer efficiency.

In addition, the insulating separator 28 includes one or more insulating materials selected from SiON, AlO, TiO, and TiSiO. This makes it possible to effectively suppress or prevent dark current flowing through the oxide semiconductor layer 21, and also improve the sealing performance.

In addition, as illustrated in FIG. 5, the oxide semiconductor layer 21 in the solid-state imaging device 1 is formed to have a thickness t such that the electron density is 1×10¹⁷ cm³ or less during the operation. In addition, as illustrated in FIG. 6, the oxide semiconductor layer 21 in the solid-state imaging device 1 is formed to have a thickness t of 10 nm or more.

This makes it possible to effectively suppress noise in the oxide semiconductor layer 21.

The method of manufacturing the solid-state imaging device 1 according to the first embodiment has the following processes.

As illustrated in FIG. 8, the oxide semiconductor layer 21 is formed above the substrate 2. As illustrated in FIG. 9, the separation groove 281 is formed between the regions where the pixels 100 are to be formed, and the separation groove 281 is formed in the thickness direction from the surface of the oxide semiconductor layer 21 on the opposite side of the substrate 2. As illustrated in FIGs. 10 and 11, the insulating film 282 is embedded in the separation groove 281 to form the insulating separator 28. As illustrated in FIG. 3, the photoelectric conversion layer 22 is formed on the surface of the oxide semiconductor layer 21.

With these processes, it is possible to easily form the insulating separator 28 that is able to effectively suppress or prevent dark current flowing through the oxide semiconductor layer 21.

In the method of manufacturing the solid-state imaging device 1, after forming the insulating separator 28, the insulating film 282 on the surface of the oxide semiconductor layer 21 is removed, and a portion of the oxide semiconductor layer 21 is removed from the surface in the thickness direction. In this process, the oxide semiconductor layer 21 is formed to have a thickness t such that an electron density is 1×10¹⁷ cm³ or less during the operation.

Furthermore, in the method of manufacturing the solid-state imaging device 1, after forming the insulating separator 28, the insulating film 282 on the surface of the oxide semiconductor layer 21 is removed, and a portion of the oxide semiconductor layer 21 is removed from the surface in the thickness direction. In this process, the oxide semiconductor layer 21 is formed to have a thickness t of 10 nm or more.

With these processes, it is possible to easily form the oxide semiconductor layer 21 that is able to effectively suppress noise.

### <2. Second Embodiment>

Referring to FIGs. 13 to 17, the following describes a solid-state imaging device 1 according to the second embodiment of the present disclosure.

For the solid-state imaging device 1 according to the second embodiment and subsequent embodiments, the same or substantially the same components as those of the solid-state imaging device 1 according to the first embodiment are denoted by the same reference numerals, and duplicate explanations will be omitted.

### [Specific Cross-Sectional Configuration of Pixel 100]

FIG. 13 illustrates an example of the specific cross-sectional configuration of pixels 100.

In the solid-state imaging device 1 according to the second embodiment, the surface of the insulating separator 28 on a side of the photoelectric conversion layer 22 is located closer to the photoelectric conversion layer 22 than the surface of the oxide semiconductor layer 21 on a side of the photoelectric conversion layer 22. In other words, the insulating separator 28 is disposed across the oxide semiconductor layer 21 and the oxide layer 210. That is, the position of the surface of the insulating separator 28 on a side of the photoelectric conversion layer 22 is the same as the position of the surface of the oxide layer 210 on a side of the photoelectric conversion layer 22.

The components other than the above are the same as those of the solid-state imaging device 1 according to the first embodiment.

### [Method of Manufacturing Solid-State Imaging Device 1]

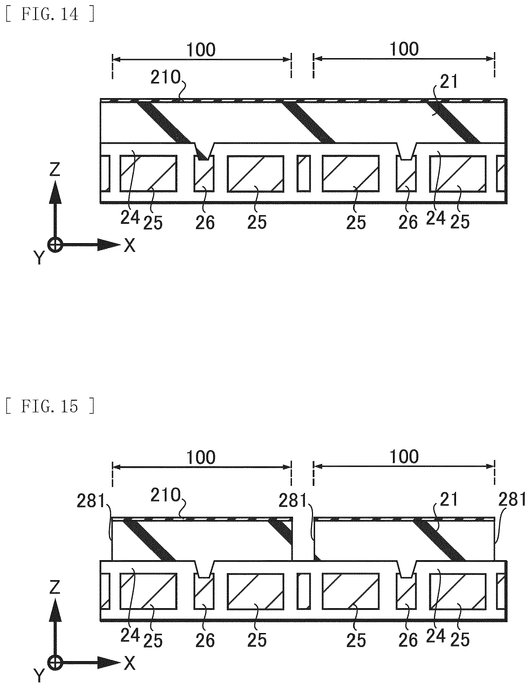

FIGs. 14 to 17 illustrate the manufacturing method of the solid-state imaging device 1 according to the second embodiment, process by process.

As illustrated in FIG. 14, after forming the oxide semiconductor layer 21 in FIG. 8 illustrating the method of manufacturing the solid-state imaging device 1 according to the first embodiment (hereinafter simply referred to as "first manufacturing method"), the oxide layer 210 is formed on the oxide semiconductor layer 21.

As illustrated in FIG. 15, the separation groove 281 is formed in the oxide layer 210 and the oxide semiconductor layer 21 between the regions where the pixels 100 are to be formed.

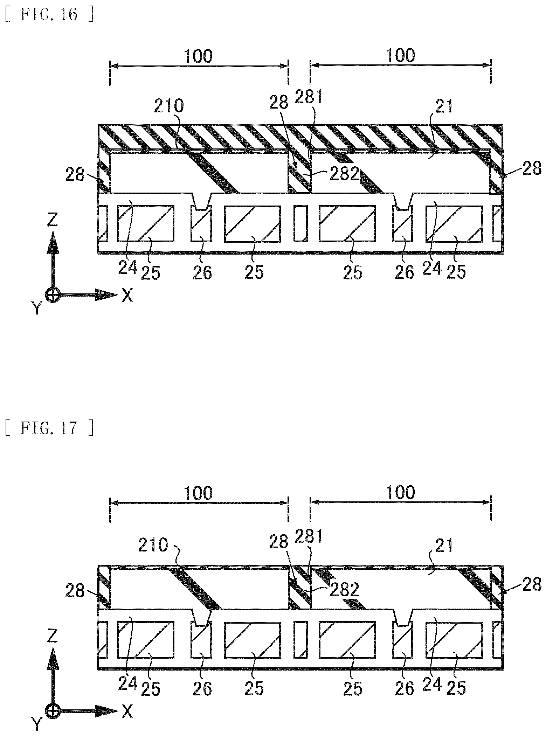

As illustrated in FIG. 16, the insulating film 282 is formed on the oxide layer 210. The insulating film 282 formed is embedded in the separation groove 281.

As illustrated in FIG. 17, excess insulating film 282 on the oxide layer 210 is removed. When the insulating film 282 is removed, the insulating separator 28 with the separation groove 281 and insulating film 282 is formed.

The photoelectric conversion layer 22 is subsequently formed on the oxide layer 210, and the transparent electrode 23 is formed on the photoelectric conversion layer 22, as illustrated in FIG. 13 described above.

Thereafter, as illustrated in FIG. 1 described above, the sealing film 30, the second filter 31, the planarizing film 32, and the optical lens 33 are formed in sequence.

When a series of these manufacturing processes ends, the solid-state imaging device 1 according to the second embodiment is completed and the manufacturing method is finished.

### [Workings and Effects]

With the solid-state imaging device 1 and the method of manufacturing the solid-state imaging device 1 according to the second embodiment, the same workings and effects are obtainable as those obtained from the solid-state imaging device 1 and the method of manufacturing the solid-state imaging device 1 according to the first embodiment.

As illustrated in FIG. 13, in the solid-state imaging device 1, the surface of the insulating separator 28 on a side of the photoelectric conversion layer 22 is located closer to the photoelectric conversion layer 22 than the surface of the oxide semiconductor layer 21 on a side of the photoelectric conversion layer 22.

This configuration is able to more reliably intercept the dark current flowing through the oxide semiconductor layer 21 because the insulating separator 28 is disposed in the entire thickness direction of the oxide semiconductor layer 21 and the oxide layer 210.

### <3. Second Embodiment>

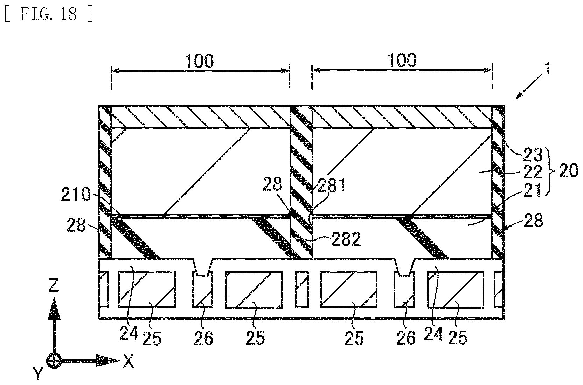

Referring to FIG. 18, the following describes a solid-state imaging device 1 according to the third embodiment of the present disclosure.

### [Specific Cross-Sectional Configuration of Pixel 100]

FIG. 18 illustrates an example of the specific cross-sectional configuration of pixels 100.

In the solid-state imaging device 1 according to the third embodiment, the surface of the insulating separator 28 on a side of the photoelectric conversion layer 22 is located closer to the photoelectric conversion layer 22 than the surface of the oxide semiconductor layer 21 on a side of the photoelectric conversion layer 22. In other words, the insulating separator 28 is disposed across the oxide semiconductor layer 21, the oxide layer 210, the photoelectric conversion layer 22, and the transparent electrode 23. The position of the surface of the insulating separator 28 on a side of the photoelectric conversion layer 22 is the same as the position of the surface of the transparent electrode 23 on a side of the optical lens 33.

For the manufacturing method, after forming the transparent electrode 23 by the first manufacturing method, the insulating separator 28 is formed.

The components other than the above are the same as those of the solid-state imaging device 1 according to the first embodiment.

### <4. Other Embodiments>

The present technology is not limited to the embodiments described above, and is modifiable in various ways without departing from the gist thereof.

For instance, the oxide layer between the oxide semiconductor layer and the photoelectric conversion layer of the second photoelectric converter may be omitted in the solid-state imaging devices of the first to third embodiments described above.

The solid-state imaging device according to the first embodiment of the present disclosure includes the oxide semiconductor layer and the photoelectric conversion layer. The oxide semiconductor layer is disposed above the substrate. The photoelectric conversion layer is stacked on the oxide semiconductor layer on the opposite side of the substrate.

In this embodiment, the solid-state imaging device further includes the insulating separator. The insulation separator is disposed in the oxide semiconductor layer between the pixels and includes an insulator.

With this configuration, the insulating separator is able to physically block the dark current flowing from a pixel to the adjacent pixel through the oxide semiconductor. This makes it possible to effectively suppress or prevent dark current, which is the cause of noise.

The method of manufacturing the solid-state imaging device according to the second embodiment of the present disclosure includes forming the oxide semiconductor layer above the substrate. Next, the separation groove is formed between the regions where the pixels are to be formed, and the separation groove is formed in the thickness direction from the surface of the oxide semiconductor layer on the opposite side of the substrate. Next, the insulating film is embedded in the separation groove to form the insulating separator. The photoelectric conversion layer is formed on the surface of the oxide semiconductor layer.

With these processes, it is possible to easily form the insulating separator that is able to effectively suppress or prevent dark current flowing through the oxide semiconductor.

### <Configuration of Present Technology>

The present technology has the following configuration. The following configuration makes it possible to provide a solid-state imaging device and a method of manufacturing the solid-state imaging device that is able to effectively suppress or prevent dark current, which causes the noise.
(1) A solid-state imaging device including:
   an oxide semiconductor layer disposed above a substrate;
   a photoelectric conversion layer stacked on the oxide semiconductor layer on an opposite side of the substrate; and
   an insulating separator disposed in the oxide semiconductor layer between pixels, the insulation separator including an insulator.
(2) The solid-state imaging device according to (1), in which a position of a surface of the insulating separator on a side of the photoelectric conversion layer is the same as a position of a surface of the oxide semiconductor layer on a side of the photoelectric conversion layer.
(3) The solid-state imaging device according to (1), in which a position of a surface of the insulating separator on a side of the photoelectric conversion layer is located closer to the photoelectric conversion layer than a position of a surface of the oxide semiconductor layer on a side of the photoelectric conversion layer.
(4) The solid-state imaging device according to (1) or (3), further including a transparent electrode on the photoelectric conversion layer on an opposite side of the oxide semiconductor layer, in which
   the insulating separator extends through the photoelectric conversion layer to the transparent electrode.
(5) The solid-state imaging device according to any one of (1) to (4), further including an oxide layer between the oxide semiconductor layer and the photoelectric conversion layer.
(6) The solid-state imaging device according to (5), in which the oxide layer includes a film stack of a metal oxide film and a tunnel oxide film.
(7) The solid-state imaging device according to (6), in which the metal oxide film includes at least one element selected from Ta, Ti, Pd, Nb, W, Zr, Hf, Sc, Y, La, Ga, and Mg.
(8) The solid-state imaging device according to (5), in which the oxide film includes at least one element added, selected from Si, Ta, Pd, Nb, W, Zr, Hf, Sc, Y, La, Ga, Mg, Al, Sr, Ge, H2, C, and N₂.
(9) The solid-state imaging device according to any one of (1) to (8), in which the oxide semiconductor layer includes IGZO, IGSiO, or IAZO.
(10) The solid-state imaging device according to any one of (1) to (9), in which the photoelectric conversion layer includes an organic photoelectric conversion layer.
(11) The solid-state imaging device according to any one of (1) to (10), in which the insulating separator includes one or more materials selected from SiO₂, SiON, AlO, TiO, and TiSiO.
(12) The solid-state imaging device according to any one of (1) to (11), in which the oxide semiconductor layer has a thickness to allow an electron density to be 1×10¹⁷ cm³ or less upon operation.
(13) The solid-state imaging device according to any one of (1) to (12), in which the oxide semiconductor layer has a thickness of 10 nm or more.
(14) A method of manufacturing a solid-state imaging device, including:
   forming an oxide semiconductor layer above a substrate;
   forming a separation groove between regions where pixels are to be formed, the separation groove being formed in a thickness direction of the oxide semiconductor layer from a surface of the oxide semiconductor layer on an opposite side of the substrate;
   forming an insulating separator by embedding an insulating film in the separation groove; and
   forming a photoelectric conversion layer on the surface.
(15) The method of manufacturing the solid-state imaging device according to (14), further including, after forming the insulating separator:
   removing the insulating film on the surface; and
   removing a part of the surface of the oxide semiconductor layer in the thickness direction to form the oxide semiconductor layer having a thickness to allow an electron density to be 1×10¹⁷ cm³ or less upon operation.
(16) The method of manufacturing the solid-state imaging device according to (14) or (15), further including, after forming the insulation separator:
   removing the insulating film on the surface; and
   removing a part of the surface of the oxide semiconductor layer in the thickness direction to form the oxide semiconductor layer having a thickness of 10 nm or more.

The present application claims the benefit of Japanese Priority Patent Application JP2022-020874 filed with the Japan Patent Office on February, 14, 2022, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A solid-state imaging device comprising:
an oxide semiconductor layer disposed above a substrate;
a photoelectric conversion layer stacked on the oxide semiconductor layer on an opposite side of the substrate; and
an insulating separator disposed in the oxide semiconductor layer between pixels, the insulation separator including an insulator.

2. The solid-state imaging device according to claim 1, wherein a position of a surface of the insulating separator on a side of the photoelectric conversion layer is same as a position of a surface of the oxide semiconductor layer on a side of the photoelectric conversion layer.

3. The solid-state imaging device according to claim 1, wherein a position of a surface of the insulating separator on a side of the photoelectric conversion layer is located closer to the photoelectric conversion layer than a position of a surface of the oxide semiconductor layer on a side of the photoelectric conversion layer.

4. The solid-state imaging device according to claim 1, further comprising a transparent electrode on the photoelectric conversion layer on an opposite side of the oxide semiconductor layer, wherein
the insulating separator extends through the photoelectric conversion layer to the transparent electrode.

5. The solid-state imaging device according to claim 1, further comprising an oxide layer between the oxide semiconductor layer and the photoelectric conversion layer.

6. The solid-state imaging device according to claim 5, wherein the oxide layer comprises a film stack of a metal oxide film and a tunnel oxide film.

7. The solid-state imaging device according to claim 6, wherein the metal oxide film includes at least one element selected from Ta, Ti, Pd, Nb, W, Zr, Hf, Sc, Y, La, Ga, and Mg.

8. The solid-state imaging device according to claim 5, in which the oxide layer includes at least one element added, selected from Si, Ta, Pd, Nb, W, Zr, Hf, Sc, Y, La, Ga, Mg, Al, Sr, Ge, H₂, C, and N₂.

9. The solid-state imaging device according to claim 1, wherein the oxide semiconductor layer includes IGZO, IGSiO, or IAZO.

10. The solid-state imaging device according to claim 1, wherein the photoelectric conversion layer comprises an organic photoelectric conversion layer.

11. The solid-state imaging device according to claim 1, wherein the insulating separator includes one or more materials selected from SiO₂, SiON, AlO, TiO, and TiSiO.

12. The solid-state imaging device according to claim 1, wherein the oxide semiconductor layer has a thickness to allow an electron density to be 1×10¹⁷ cm³ or less upon operation.

13. The solid-state imaging device according to claim 1, wherein the oxide semiconductor layer has a thickness of 10 nm or more.

14. A method of manufacturing a solid-state imaging device, the method comprising:
forming an oxide semiconductor layer above a substrate;
forming a separation groove between regions where pixels are to be formed, the separation groove being formed in a thickness direction of the oxide semiconductor layer from a surface of the oxide semiconductor layer on an opposite side of the substrate;
forming an insulating separator by embedding an insulating film in the separation groove; and
forming a photoelectric conversion layer on the surface.

15. The method of manufacturing the solid-state imaging device according to claim 14, further comprising, after forming the insulating separator:
removing the insulating film on the surface; and
removing a part of the surface of the oxide semiconductor layer in the thickness direction to form the oxide semiconductor layer having a thickness to allow an electron density to be 1×10¹⁷ cm³ or less upon operation.

16. The method of manufacturing the solid-state imaging device according to claim 14, further comprising, after forming the insulating separator:
removing the insulating film on the surface; and
removing a part of the surface of the oxide semiconductor layer in the thickness direction to form the oxide semiconductor layer having a thickness of 10 nm or more.
